# DEMANDE DE BREVET EUROPEEN

(11) **EP 0 614 329 A1**
(43) Date de publication de la demande: **07.09.1994**
(21) Numéro de dépôt: 94400468.8
(22) Date de dépôt: 04.03.1994
(51) Int. Cl.: H05K 5/00

(54) **Procédé de fermeture hermétique d'enceinte, en particulier d'enceinte contenant des circuits microélectroniques, et enceinte ainsi obtenue**

(30) Priorité: 05.03.1993 FR 9302588
(71) Demandeur: THOMSON-CSF, 75008 Paris (FR)
(72) Inventeur: Bonniau, Philippe, F-92402 Courbevoie Cedex (FR); Estang, Bernard, F-92402 Courbevoie Cedex (FR); Malgouyres, Michel, F-92402 Courbevoie Cedex (FR)
(74) Mandataire: Chaverneff, Vladimir

(57) **Abrégé**

Le procédé de l'invention consiste à souder le couvercle (17) au boîtier (15) par des traits de soudure laser (18), puis à colmater les interstices avec un produit de colmatage polymérisable.

Application: boîtiers étanches pour circuits de microélectronique.

## Description

La présente invention se rapporte à un procédé de fermeture hermétique d'enceinte, en particulier d'enceinte contenant des circuits microélectroniques, et à une enceinte ainsi obtenue.

Les caractéristiques micrométriques de dispositifs à composants et circuits de liaison utilisés en technologie microélectronique imposent le conditionnement de ces dispositifs en enceintes sous atmosphère neutre pour éviter tout risque d'amorce de corrosion ou court-circuit, dont le développement serait dommageable au fonctionnement de ces dispositifs, compte tenu des très faibles dimensions de leurs composants, de leurs pistes de liaison, ... L'herméticité de ces enceintes doit être de très haut niveau (fuites inférieures à 1.10⁻² Pa.cm³/s).

Selon l'art antérieur, on utilise trois types de fermetures pour ces enceintes.

En premier lieu, on réalise l'enceinte à partir d'un boîtier usiné dans un bloc métallique en Kovar ou en Titane. Ces matériaux ont des coefficients de dilatation thermique adaptés à celui des substrats des circuits microélectroniques. On réalise séparément un couvercle avec le même matériau, et on le colle sur tout son pourtour au boîtier.

Un deuxième type de fermetures part des mêmes éléments que ceux cités ci-dessus. Le couvercle est fixé sur le boîtier par des vis, assurant la fonction de maintien mécanique. Une gorge est préalablement formée dans la face du boîtier qui sera en contact avec le couvercle, et elle est remplie d'un produit siliconé de colmatage.

Ces deux premiers types de fermetures nécessitent des parois de boîtiers relativement épaisses pour permettre soit d'avoir des surfaces de collage suffisantes, soit pour loger les vis et la gorge. L'augmentation de poids due à l'augmentation d'épaisseur des parois des boîtiers est un inconvénient important pour des équipements aéroportés, et cette augmentation d'épaisseur diminue d'autant, pour un encombrement donné du boîtier, l'espace disponible pour l'implantation des composants disposés dans l'enceinte et pour leur substrat.

Un troisième type de fermeture, qui consiste à souder par rayon laser le couvercle sur le boîtier, permet de diminuer l'épaisseur de la paroi du boîtier. La soudure laser doit simultanément assurer la fixation du couvercle et l'herméticité de l'enceinte. Dans le cas où l'enceinte est disposée dans une zone non pressurisée d'un avion, les changements de pression dus aux variations d'altitude sollicitent fortement la soudure du couvercle, ce qui peut aboutir à des pertes d'herméticité après plusieurs cycles de variations de pression. En outre, dans le cas où les boîtiers ont de grandes dimensions (de l'ordre de 100x200 mm ou plus) et comportent des cloisons internes, la soudure par rayon laser le long du périmètre de fermeture et sur les cloisons internes produit une déformation importante du boîtier sous forme de gauchissement (de l'ordre de 1 à 2 mm pour un boîtier dont la plus grande dimension est d'environ 200 mm). Un tel gauchissement (vrillage) est un inconvénient très important lorsque les enceintes sont utilisées dans des structures refroidissantes à glissières thermiques qui ne tolèrent que quelques dixièmes de millimètre de gauchissement.

La présente invention a pour objet un procédé de fermeture hermétique d'enceinte, en particulier d'enceinte contenant des équipements microélectroniques, permettant d'utiliser une enceinte dont les parois soient le plus fines possible et lui garantissant une bonne tenue mécanique en fonction de contraintes mécaniques et thermiques, ainsi qu'une bonne herméticité, ce dispositif étant facile à mettre en oeuvre et le moins onéreux possible. La présente invention a également pour objet une enceinte ainsi obtenue.

Le procédé de fermeture conforme à l'invention, pour une enceinte métallique hermétique, du type comportant un boîtier dont une face est ouverte, et un couvercle refermant cette face, consiste à réaliser sur tout le pourtour du couvercle des traits de soudure par laser et à colmater la jointure entre le couvercle et le boîtier.

Selon un premier aspect du procédé de l'invention, on amincit avant soudage la paroi latérale du boîtier sur tout son pourtour extérieur près de la face qui sera en contact avec le couvercle, et on remplit de produit de colmatage, après soudage, la gorge ainsi formée.

Selon un autre aspect du procédé de l'invention, on forme dans le couvercle, avant soudage, le long de la ligne de soudage, des fentes entre lesquelles on pratique ensuite les traits de soudage, et après soudage on remplit les fentes d'un produit de colmatage.

L'enceinte conforme à l'invention comporte un corps de boîtier en une pièce sur lequel est soudé un couvercle par traits de soudure, et un produit de colmatage assurant l'herméticité de la fermeture.

L'invention sera mieux comprise à la lecture de la description détaillée de plusieurs exemples de mise en oeuvre, pris à titre d'exemples non limitatifs et illustrés par le dessin annexé, sur lequel:
- les figures 1 à 3 sont des vues partielles simplifiées de dispositifs de fermeture d'enceintes selon l'art antérieur ;
- les figures 4 et 5 sont respectivement une vue partielle en coupe et une vue partielle en perspective d'un premier mode de réalisation de l'invention ;
- les figures 6 et 7 sont des vues partielles simplifiées, respectivement en perspective et en coupe selon VII-VII de la figure 6 ;
- la figure 8 est une vue montrant une étape du procédé de colmatage pouvant être mise en oeuvre par la présente invention.

L'invention est expliquée ci-dessous en référence à la fabrication d'une enceinte hermétique contenant des circuits microélectroniques, mais il est bien entendu qu'elle n'est pas limitée à une telle application, et qu'elle peut être mise en oeuvre pour des enceintes hermétiques comportant d'autres dispositifs.

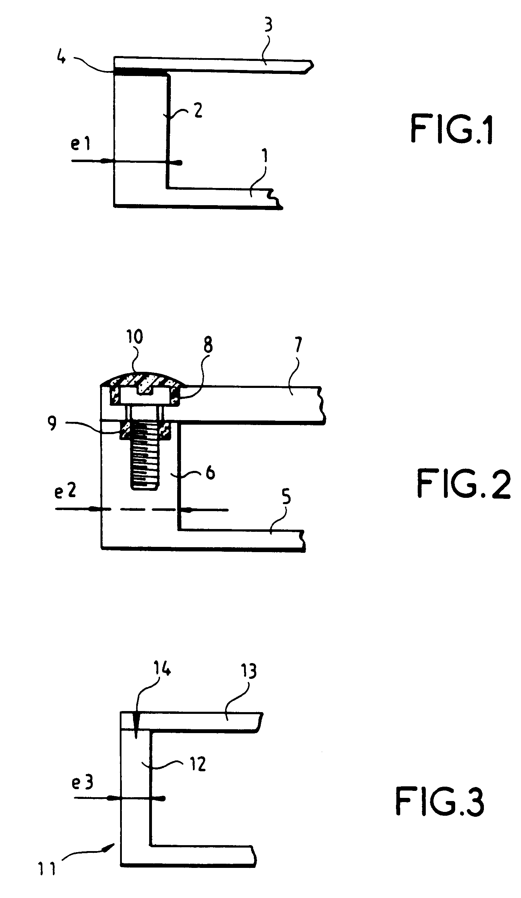

On a représenté en figure 1 un premier exemple de réalisation de fermeture pour enceinte de l'art antérieur. Le boîtier 1 comprend essentiellement un fond 1 et une paroi périphérique 2. Ce boîtier a par exemple une forme de parallélépipède rectangle sans sa face supérieure. Le fond 1 et la paroi 2 sont usinés, par exemple par fraisage, à partir d'un bloc métallique (Kovar, Titane, ...). La paroi 2 est relativement épaisse (par exemple d'épaisseur e1 = 3 mm ou plus) pour permettre le collage ultérieur hermétique d'un couvercle 3 à l'aide d'un dépôt de colle 4.

On a représenté en figure 2 un autre mode de réalisation d'enceinte selon l'art antérieur. Le boîtier, similaire au boîtier de la figure 1, et usiné de façon semblable, comporte un fond 5 et une paroi périphérique 6. Cette paroi 6 est un peu plus épaisse (épaisseur e2 d'au moins 4 mm) que la paroi 2, afin de permettre la fixation du couvercle 7 à l'aide de vis 8. Une gorge 9 est formée sur la face supérieure de la paroi 6 et est remplie d'un produit siliconé de colmatage. On dépose également du produit de colmatage 10 sur les têtes des vis 8.

Selon le mode de réalisation de la figure 3 de l'art antérieur, on usine un boîtier 11 dont les parois 12 sont plus fines (épaisseur e3 d'environ 1,6 mm) que celles des modes de réalisation précédents, et on soude le couvercle 13 sur tout son pourtour par soudure 14 au rayon laser.

Les inconvénients de ces modes de réalisation connus ont été cités ci-dessus et ne seront pas détaillés davantage.

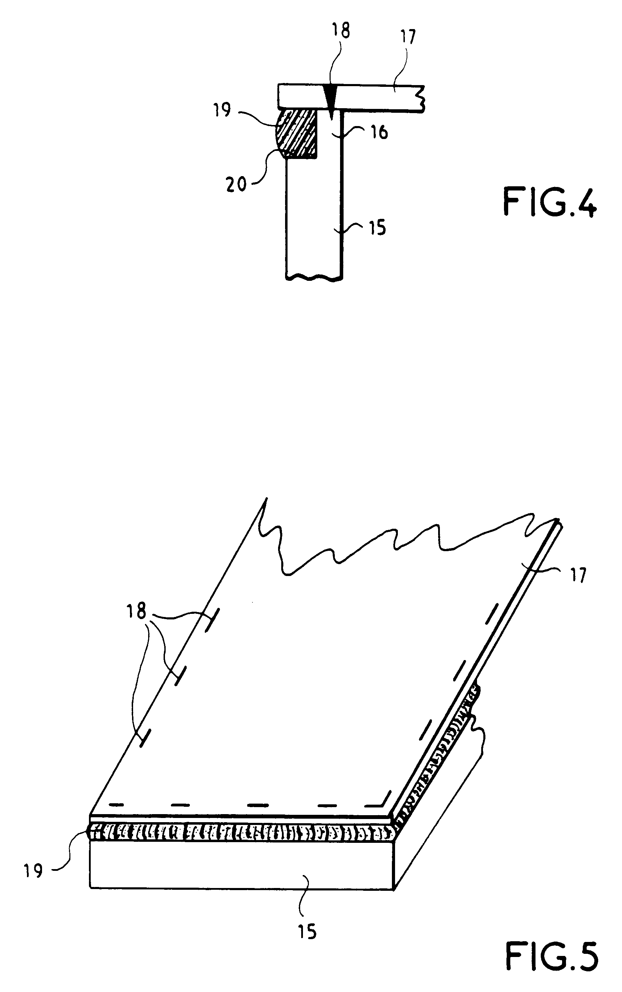

On a schématiquement représenté en figures 4 et 5 un premier mode de réalisation d'une fermeture conforme à l'invention. On amincit extérieurement la paroi latérale 15 à sa partie supérieure, sur tout son pourtour. L'épaisseur de la paroi 15 est par exemple d'environ 1, 6 à 2 mm, et l'épaisseur de sa partie supérieure amincie 16 est par exemple d'environ 0,8 à 1 mm.

On soude le couvercle 17 à la partie de paroi 16 par des traits de soudure 18 au rayon laser. Ces traits, régulièrement répartis le long du trajet de soudage, ont par exemple une longueur de 3 mm et sont espacés de 25 à 30 mm. Ainsi, on minimise la longueur des parties soudées, ce qui évite la déformation par vrillage du boîtier.

On procède ensuite à l'hermétisation en disposant un produit de colmatage polymérisable 19 dans la gorge 20 formée par l'amincissement de la partie supérieure de la paroi latérale. Ce produit de colmatage est par exemple un produit à base de silicones.

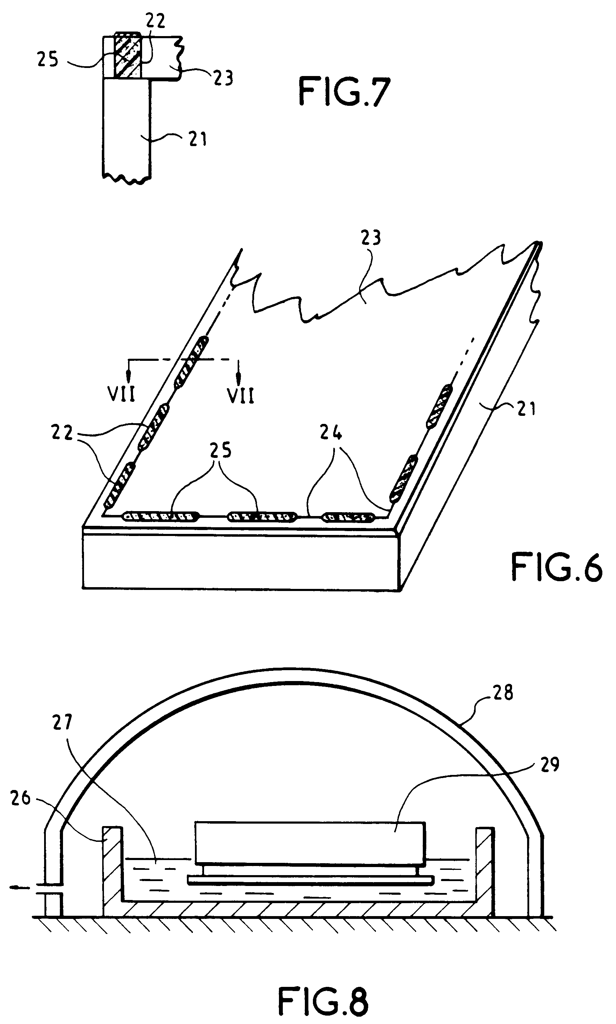

Selon le mode de réalisation schématiquement représenté en figures 6 et 7, on n'amincit pas la paroi latérale 21 du boîtier, mais on pratique des fentes 22 dans le couvercle 23, le long du trajet de soudage. Ces fentes 22 ont par exemple une longueur d'environ 25 à 30 mm et sont espacées d'environ 3 mm. Leur largeur est, bien entendu, inférieure à l'épaisseur de la paroi 21.

On réalise des soudures laser 24 entre les fentes, ce qui fait que les traits de soudure ont les mêmes longueur et espacement que dans le cas des figures 4 et 5. On dispose ensuite un produit de colmatage 25 dans les fentes 22, étant bien entendu que les traits de soudure 24 s'étendent jusqu'au bord des fentes qui leur sont respectivement adjacentes, et que ces traits de soudure assurent l'herméticité sur toute leur longueur.

Afin de faciliter le remplissage en produit de colmatage des gorges 20 ou des fentes 22, tout en évitant la pénétration du produit de colmatage à l'intérieur des enceintes, avant sa polymérisation, on dispose le bac 26 contenant le produit de colmatage liquide 27 dans une cloche sous vide 28, et on dispose le ou les boîtiers 29 à l'envers dans le bac 26. Cette étape a par exemple une durée d'environ 30 minutes.

A la fin de l'étape de remplissage, avant polymérisation, on applique une légère surpression (par exemple, quelques dizaines de m Bar pendant quelques dizaines de minutes) dans la cloche 28 pour faciliter la pénétration du produit de colmatage au fond des gorges 20 dans les éventuels interstices entre le couvercle 17 et la paroi 16, ou au fond des fentes 22 dans les éventuels interstices entre le couvercle 23 et la paroi 21, sans toutefois pénétrer à l'intérieur du boîtier.

Si le boîtier comporte des cloisons intérieures ayant la même hauteur que ses parois latérales, on peut souder le couvercle à ces cloisons par des traits de soudure laser ayant les mêmes dimensions et espacement que les traits de soudure 18 du mode de réalisation des figures 4 et 5.

## Revendications

1. Procédé de fermeture pour une enceinte métallique hermétique, du type comportant un boîtier (15, 21) dont une face est ouverte, et un couvercle (17, 23) refermant cette face, caractérisé par le fait que l'on réalise sur tout le pourtour du couvercle des traits de soudures par laser (18, 24) et que l'on colmate (19, 25) la jointure entre le couvercle et le boîtier.

2. Procédé selon la revendication 1, caractérisé par le fait que l'on amincit (16) avant soudage la paroi latérale du boîtier sur tout son pourtour extérieur, près de la face qui sera en contact avec le couvercle, et que l'on remplit de produit de colmatage (19), après soudage, la gorge (20) ainsi formée.

3. Procédé selon la revendication 1, caractérisé par le fait que l'on forme dans le couvercle, avant soudage, le long de la ligne de soudage, des fentes (22) entre lesquelles on pratique ensuite les traits de soudage (24), et qu'après soudage on remplit les fentes d'un produit de colmatage (25).

4. Procédé selon l'une des revendications précédentes, caractérisé par le fait que le produit de colmatage est un produit à base de silicones.

5. Procédé selon l'une des revendications précédentes, caractérisé par le fait que le colmatage est réalisé en disposant à l'envers les boîtiers soudés (29) dans un bain (26) de produit de colmatage liquide, sous vide.

6. Procédé selon la revendication 5, caractérisé par le fait qu'avant polymérisation on applique une légère surpression au bain pour faciliter la pénétration du produit de colmatage.

7. Enceinte métallique hermétique, caractérisée par le fait que son couvercle (17, 23) est soudé au boîtier (15, 21) par des traits de soudure (18, 24), et qu'un produit de colmatage (19, 25) est disposé entre le couvercle et le boîtier.
